(19) Europäisches Patentamt
European Patent Office
Office européen des brevets

(11) **EP 1 556 883 B1**

(12) **FASCICULE DE BREVET EUROPEEN**

(45) Date de publication et mention
de la délivrance du brevet:
**30.05.2007 Bulletin 2007/22**

(21) Numéro de dépôt: **03769081.5**

(22) Date de dépôt: **22.10.2003**

(51) Int Cl.:
***H01J 37/34*** *(2006.01)*

(86) Numéro de dépôt international:
**PCT/BE2003/000179**

(87) Numéro de publication internationale:
**WO 2004/038756 (06.05.2004 Gazette 2004/19)**

(54) **METHODE DESTINEE A LA PULVERISATION CATHODIQUE MAGNETRON**

VERFAHREN ZUR KATHODISCHEN MAGNETRON-ZERSTÄUBUNG

METHOD FOR MAGNETRON SPUTTERING

(84) Etats contractants désignés:
**AT BE BG CH CY CZ DE DK EE ES FI FR GB GR HU IE IT LI LU MC NL PT RO SE SI SK TR**
Etats d'extension désignés:
**LT LV**

(30) Priorité: **23.10.2002 BE 200200606**

(43) Date de publication de la demande:
**27.07.2005 Bulletin 2005/30**

(73) Titulaire: **Alloys for Technical Applications S.A.**
**5590 Ciney-Achene (BE)**

(72) Inventeurs:
• **CLAVAREAU, Guy**
**B-5370 Havelange (BE)**
• **LEFEVRE, Patrick**
**B-56000 Romedenne (BE)**

(74) Mandataire: **Cauchie, Daniel**
**Office Parette (Fred Maes),**
**Avenue Gabrielle Petit 2**
**7940 Brugelette (BE)**

(56) Documents cités:
**US-A- 4 892 633          US-A- 5 286 361**
**US-A- 5 415 754**

**Description**

La présente invention se rapporte, d'une manière générale, à une méthode pour améliorer l'uniformité de l'érosion sur la surface de pulvérisation d'une cible de pulvérisation cathodique magnétron.

La méthode bien connue pour le recouvrement d'un substrat par une fine pellicule de matière, généralement appelée « sputtering », repose sur la pulvérisation de cette matière lorsqu'une différence de potentiel de plusieurs centaines de volts est appliquée entre deux plaques dans une enceinte remplie d'un gaz à une pression d'environ 0,3 à 7 pascals.

Le gaz, généralement un gaz rare tel que le néon ou le krypton habituellement l'argon, est ionisé à cette pression sous l'action du champ électrique et les ions positifs formés bombardent la cathode provoquant le transport de matière depuis la cible de pulvérisation cathodique vers le substrat anodique.

Une cathode de pulvérisation cathodique classique est généralement constituée d'une plaque de base polaire sur laquelle reposent des aimants permanents situés en son centre et sur sa périphérie, les aimants centraux étant de polarité inverse de celle des aimants latéraux.

Au surplus, une plaque de refroidissement est disposée entre les aimants et la cible que ce refroidissement soit direct ou indirect tandis que les aimants, vu leur sensibilité à la chaleur, sont refroidis par un circuit d'eau.

Les aimants ainsi disposés créent une induction magnétique qui, couplée au champ électrique existant, permet d'augmenter la trajectoire des électrons de manière à confiner le plasma au niveau de la cible. Ce confinement est important car il permet d'augmenter la vitesse de dépôt lors de la pulvérisation cathodique de la cible, et il est maximum lorsque le champ électrique et l'induction magnétique sont perpendiculaires, c'est-à-dire lorsque l'induction magnétique est parallèle à la cible.

Or, vu la forme de l'induction magnétique due aux aimants et son manque d'uniformité, l'espace où cette induction magnétique est parallèle à la cible est très limité et la densité du plasma produit se présente de manière non uniforme, ce qui provoque des taux différents de pulvérisation à la surface de la cible et une usure typique de celle-ci en forme de V et en forme de champ de course (« race-track »). Dans le meilleur des cas, seulement 30 % de la cible peut être utilisé.

Pour améliorer le taux de pulvérisation, il s'avère, par conséquent, nécessaire de modifier la distribution de l'induction magnétique de manière à améliorer l'uniformité de l'érosion de la cible.

Différentes solutions ont été proposées, la plupart d'entre elles consistant à modifier l'assemblage cathodique fixe.

A titre d'exemple, on a proposé dans le brevet US 4198283, un assemblage cathodique magnétron comprenant notamment une cible de pulvérisation et modifié par ajout de pièces polaires fixées à la plaque support de la cible, ces pièces polaires étant destinées à accentuer la courbure du champ magnétique sous forme de boucle fermée au-dessus de la surface de la cible.

De même, le brevet britannique, GB 2209769 décrit un système de pulvérisation dont les moyens inducteurs d'un champ magnétique incluent un matériau magnétique s'étendant en direction de l'anode au-delà de la surface supportant la cible sur son côté éloigné de l'anode. Ce matériau polaire est séparé de la cible circulaire par un anneau en aluminium.

En outre, on a exposé dans l'article extrait de « 38th Annual Technical Conference Proceeding » page 414, une méthode pour accroître la performance de cibles planes pour pulvérisation magnétron par utilisation d'une pièce ferromagnétique de liaison placée entre l'assemblage des aimants et la cible de façon à modifier favorablement le champ magnétique au niveau de la surface de cette cible.

Par ailleurs, on a rapporté dans la demande de brevet EP 1063679, une méthode permettant de réduire l'érosion locale excessive d'une cible de pulvérisation utilisée avec un magnétron mobile par rapport à cette cible. Selon cette méthode, on introduit entre l'assemblage des aimants et la cible et à des endroits où apparaissent des pics d'érosion, une ou plusieurs pièces polaires capables d'agir sur le champ magnétique et induire, en conséquence, une réduction de l'érosion locale excessive sans influencer le reste du procédé d'érosion sur la cible.

De même, la demande de brevet JP 03271366 propose de disposer une pièce ferromagnétique dans l'anneau d'érosion d'une cible de pulvérisation par insertion totale ou partielle ou par juxtaposition à celle-ci de manière à contrôler le plasma produit à l'aide d'un champ magnétique extérieur induit par un solénoïde.

Par contre, la demande de brevet EP 0393957 envisage l'utilisation d'une pièce ferromagnétique encastrée dans une rainure pratiquée dans la paroi arrière d'une cible de pulvérisation de manière à renforcer la paroi centrale du support de la cible également encastré dans celle-ci et la cible elle-même contre une expansion radiale causée par la chaleur.

L'ensemble des méthodes évoquées ci-dessus nécessitent l'apport de modifications parfois très lourdes au niveau du dispositif fixe de pulvérisation représenté par le magnétron en particulier l'assemblage cathodique fixe. Comme ces modifications doivent tenir compte non seulement des caractéristiques du magnétron ou de sa cathode de pulvérisation mais également des propriétés de la cible utilisée, tout changement de ces propriétés risque, en conséquence, de rendre inefficaces les modifications en question et d'en éliminer les avantages recherchés au niveau de l'érosion de cette cible.

La présente invention a pour but de proposer une méthode pour uniformiser l'érosion sur l'ensemble de la surface de pulvérisation d'une cible de pulvérisation qui permet de pallier les inconvénients de l'état de la technique et notamment d'éviter d'apporter des modifications à l'assemblage fixe du magnétron.

Pour atteindre ce but, la méthode pour améliorer l'uniformité de l'érosion sur la surface de pulvérisation d'une cible de pulvérisation cathodique magnétron est caractérisée en ce que l'on ajoute à ladite cible destinée à être couplée à un magnétron maintenu stationnaire par rapport à celle-ci, au moins une pièce ferromagnétique par insertion totale ou partielle dans cette cible ou par juxtaposition à celle-ci, de manière à provoquer, au niveau de l'ensemble de la surface de pulvérisation, une réduction de la courbure des lignes d'induction magnétique créées par le magnétron.

A la suite de la pose d'un nombre suffisant de telles pièces ferromagnétiques ayant des caractéristiques d'emplacement de forme et de grandeur appropriées, on observe en fait une réduction de la courbure des lignes d'induction magnétique se traduisant généralement par un accroissement du parallélisme de ces lignes par rapport à la surface de la cible jusqu'à atteindre une augmentation significativement importante du taux de lignes d'induction magnétique parallèles. Cette évolution vers un parallélisme accru des lignes d'induction magnétique se marque d'ailleurs au niveau de la surface de pulvérisation dans son ensemble.

En conséquence, selon une caractéristique préférée de l'invention, l'on ajoute au moins une pièce ferromagnétique par insertion totale ou partielle dans cette cible ou par juxtaposition à celle-ci, de manière à provoquer, au niveau de l'ensemble de la surface de pulvérisation, une réduction de la courbure des lignes d'induction créées par le magnétron se traduisant par un accroissement du parallélisme de ces lignes d'induction.

Selon une autre caractéristique particulière et préférée, la ou les pièces ferromagnétiques sont insérées complètement ou partiellement dans la cible.

Cette pièce ferromagnétique, faisant partie de la méthode selon l'invention, est constituée de matériau perméable au champ magnétique tel qu'acier, fer doux ou alliage magnétique doux (« PERMALLOY® ») par exemple un alliage fer-nickel comportant éventuellement un autre métal comme le molybdène.

Elle peut être, selon le cas, insérée complètement ou partiellement dans la cible en remplacement d'une portion extraite de celle-ci. En tout état de cause, cette portion extraite est remplacée en totalité par une portion correspondante de pièce ferromagnétique.

Dans d'autres cas, cette pièce polaire peut être juxtaposée à la cible, c'est-à-dire placée contre l'une des parois de celle-ci habituellement en contact direct avec la paroi opposée à la surface de pulvérisation.

Lorsque la cible est constituée d'un matériau à bas point de fusion tel que le zinc, la ou les pièces ferromagnétiques seront insérées ou juxtaposées, préférentiellement et dans la mesure du possible, aux extrémités de cette cible ou à sa face inférieure, c'est-à-dire la face opposée à la surface de pulvérisation, pour maintenir un refroidissement efficace de ladite cible et éviter sa liquéfaction.

En conséquence, selon une autre caractéristique de l'invention, lorsque la cible est constituée d'un matériau à bas point de fusion, la ou les pièces ferromagnétiques sont insérées à partir des extrémités de cette cible ou de sa face inférieure ou juxtaposées aux extrémités de cette cible ou à sa face inférieure.

D'autre part, la pièce ferromagnétique, lorsqu'elle est insérée dans la cible, peut constituer également un indicateur de fin d'utilisation de cette cible lorsque l'érosion de celle-ci aura atteint la pièce ferromagnétique en question.

En conséquence selon un autre de ses aspects, l'invention se rapporte à une méthode pour améliorer l'uniformité de l'érosion sur la surface de pulvérisation d'une cible de pulvérisation cathodique magnétron et pour indiquer la fin d'utilisation de cette cible, caractérisée en ce que l'on ajoute, à ladite cible destinée à être couplée à un magnétron maintenu stationnaire par rapport à celle-ci, au moins une pièce ferromagnétique par insertion totale ou partielle dans cette cible ou par juxtaposition à celle-ci, de manière à provoquer, au niveau de l'ensemble de la surface de pulvérisation, une réduction de la courbure des lignes d'induction magnétique créées par le magnétron se traduisant, en particulier, par un accroissement du parallélisme de ces lignes d'induction.

Quant à la cible, celle-ci, généralement plane, peut adopter différentes formes telles que forme circulaire ou rectangulaire avec angles arrondis ou non.

Selon une caractéristique supplémentaire de l'invention, l'on ajoute au moins une pièce ferromagnétique dont les caractéristiques d'emplacement, de forme et de grandeur sont prédéterminées à partir des caractéristiques physiques du magnétron.

En outre, selon une autre caractéristique préférée de l'invention, l'on ajoute au moins une pièce ferromagnétique dont les caractéristiques d'emplacement, de forme et de grandeur sont prédéterminées, à partir des caractéristiques physiques du magnétron, en :

(a) comparant les valeurs mesurées et les valeurs modélisées d'une part de l'induction magnétique totale créée par le magnétron à la surface de pulvérisation de la cible et d'autre part de la composante verticale de cette induction magnétique,

(b) recherchant dans cette induction modélisée les caractéristiques d'emplacement, de forme et de grandeur d'au moins une pièce ferromagnétique capable de provoquer, au niveau de ladite surface de pulvérisation, la réduction souhaitée de la courbure des lignes d'induction magnétique se traduisant, en particulier, par l'accroissement souhaité du parallélisme de ces lignes d'induction,

(c) optimisant, au moyen du paramètre $\dfrac{B_z}{B_{total}}$, les

caractéristiques d'emplacement, de forme et de grandeur recherchés.

De même, selon une caractéristique particulière et préférée de l'invention, l'on ajoute au moins une pièce ferromagnétique dont les caractéristiques d'emplacement, de forme et de grandeur sont prédéterminées, à partir des caractéristiques physiques du magnétron, en :

(a) mesurant les valeurs de l'induction magnétique totale créée par le magnétron et de la composante verticale de cette induction magnétique,
(b) modélisant, par technique informatique assistée par logiciel, l'induction magnétique totale et sa composante verticale,
(c) comparant les valeurs modélisées, d'une part de l'induction magnétique totale et d'autre part de sa composante verticale, avec les valeurs mesurées correspondantes,
(d) recherchant, dans cette induction modélisée, les caractéristiques d'emplacement de forme et de grandeur d'au moins une pièce ferromagnétique capable de provoquer, au niveau de ladite surface de pulvérisation, la réduction souhaitée de la courbure des lignes d'induction magnétique se traduisant, en particulier, par l'accroissement souhaité du parallélisme de ces lignes d'induction,

(e) optimisant au moyen du paramètre $\dfrac{Bz}{B_{total}}$, les emplacement, forme et grandeur recherchés.

Ainsi, l'insertion ou la juxtaposition d'au moins une pièce ferromagnétique est réalisée après avoir prédéterminé non seulement l'emplacement mais également la forme et la grandeur de cette pièce.

Généralement et préférentiellement, on effectue cette prédétermination de position, forme et grandeur de pièce à l'aide d'une modélisation bidimensionnelle ou tridimensionnelle de l'induction magnétique, obtenue par technique informatique assistée par logiciel approprié.

Cette modélisation permet de visualiser la géométrie de l'induction magnétique, l'induction magnétique elle-même et les lignes d'induction magnétique calculées au préalable. On valide ensuite cette modélisation par comparaison entre les valeurs calculées d'induction magnétique et les valeurs mesurées correspondantes.

En outre, on valide également la modélisation pour la composante verticale de l'induction modélisée par comparaison entre les valeurs calculées de cette composante verticale et les valeurs correspondantes mesurées.

Dans une étape suivante, on intègre dans l'induction magnétique modélisée, une pièce ferromagnétique virtuelle, et on recherche la modification souhaitée de l'induction magnétique par translation de cette pièce dans l'induction modélisée en vue d'augmenter la courbure des lignes d'induction magnétique au niveau de la surface de pulvérisation de la cible virtuelle intégrée dans la modélisation ou, d'une autre manière, en vue de diminuer la valeur de la composante d'induction magnétique verticale, soit Bz.

Sachant que l'ajout de cette pièce ferromagnétique diminue l'induction magnétique totale, soit $B_{total}$, représenté par la racine carrée de $(Bx^2 + By^2 + Bz^2)$ à l'endroit d'intégration dans la cible ou de juxtaposition à celle-ci, on optimise la position, la forme et la dimension de cette pièce dans l'induction modélisée.

Comme une augmentation du parallélisme des lignes d'induction magnétique au-dessus de la surface de pulvérisation de la cible est préférentiellement recherchée, cette optimisation a pour but de sélectionner la ou les zones d'induction magnétique où la valeur du paramètre $\dfrac{Bz}{B_{total}}$ est la plus faible possible tout en gardant une induction magnétique suffisante pour un confinement efficace des électrons au niveau de la surface de pulvérisation de la cible, généralement une induction au moins égale à 100 gauss.

Lorsque ce paramètre est nul, les lignes d'induction magnétique sont parfaitement parallèles à la cible et s'il est égal à 1, ces lignes sont purement verticales.

Il suffit alors de repérer, sur la cible de pulvérisation réelle, l'emplacement optimisé pour la pose de la pièce ferromagnétique réelle de forme et de grandeur ainsi définies et de procéder à l'insertion ou à la juxtaposition de cette pièce.

Cette insertion se pratique habituellement selon des techniques connues après avoir extrait, par découpe, la portion nécessaire de cible et consiste à remplacer celle-ci par une portion équivalente de pièce ferromagnétique dont la forme a été obtenue notamment par usinage.

Quant à la juxtaposition de la pièce ferromagnétique à la cible de pulvérisation, celle-ci s'opère généralement de manière connue par exemple par collage.

La méthode, selon l'invention, destinée à la pulvérisation cathodique magnétron présente des avantages incontestables par rapport à l'état de la technique. En fait, la mise en oeuvre de cette méthode permet d'augmenter l'uniformisation de l'usure de la cible de pulvérisation, ce qui se traduit par un élargissement significatif de la zone d'érosion et par une réduction concomitante du sillon d'érosion en forme de V. De cette manière, l'utilisation de la cible peut être considérablement améliorée puisqu'il est possible d'atteindre un taux d'érosion de l'ordre de 70 %.

En outre, l'application de cette méthode présente l'avantage supplémentaire d'éviter toute modification du magnétron mais d'agir uniquement au niveau de la cible qui représente un élément amovible et facilement accessible sur un magnétron.

L'invention sera mieux comprise et d'autres buts, caractéristiques et avantages de celle-ci apparaîtront plus clairement au cours de la description explicative qui va suivre faite en référence aux dessins schématiques annexés donnés uniquement à titre d'exemples illustrant des exemples de réalisation de l'invention et dans lesquels:

- la figure 1 est une représentation schématique d'une coupe frontale d'une cathode de pulvérisation magnétron munie d'une cible de pulvérisation
- la figure 2 est une représentation graphique bidimensionnelle de la mesure de l'induction magnétique totale au niveau de la surface de pose de la cible de pulvérisation
- la figure 3 est une représentation graphique bidimensionnelle de la mesure de la composante verticale de l'induction magnétique à la figure 2
- la figure 4 est une représentation bidimensionnelle d'une modélisation de l'induction magnétique au-dessus de la surface de pulvérisation de la cible à la figure 1
- la figure 5 est une représentation graphique bidimensionnelle comparative de la mesure de l'induction magnétique totale à la figure 2 et du calcul de la même induction magnétique totale
- la figure 6 est une représentation graphique bidimensionnelle comparative de la mesure de la composante d'induction magnétique verticale à la figure 3 et du calcul de la même composante magnétique verticale
- la figure 7 est une représentation graphique du quotient $\dfrac{Bz}{B_{total}}$ pour l'induction magnétique calculée à la surface de pulvérisation de la cible
- la figure 8 est une représentation graphique bidimensionnelle de la modélisation à la figure 3 avec pièce ferromagnétique
- la figure 9 est une représentation graphique bidimensionnelle comparative de l'induction magnétique totale calculée au niveau de la surface de pulvérisation de la cible avec ou sans pièce ferromagnétique
- les figures 10 à 11 sont des représentations graphiques bidimensionnelles comparatives d'une simulation informatique de l'érosion de cibles avec ou sans pièce ferromagnétique

EXEMPLE 1

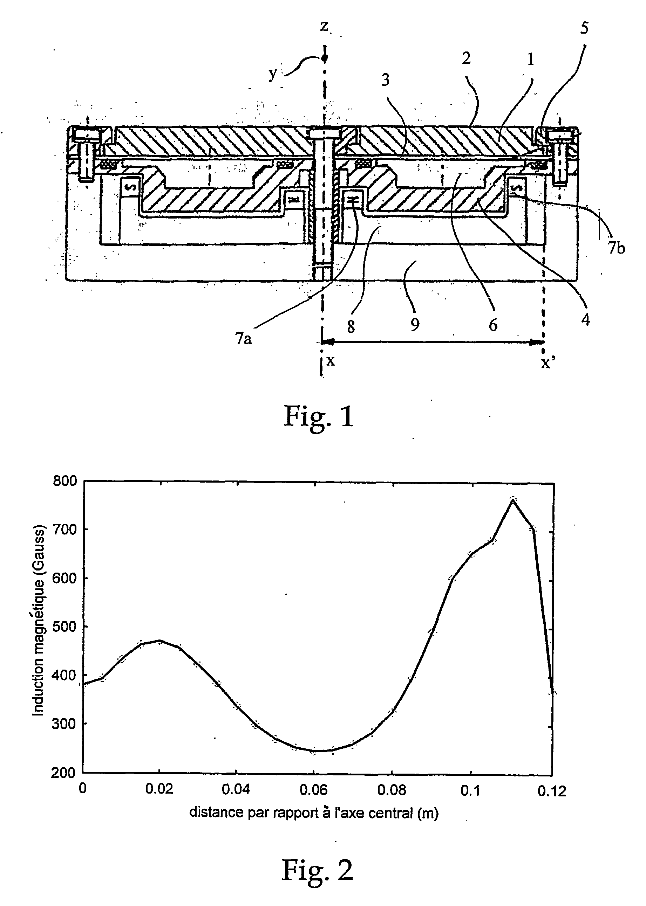

Sur un magnétron équipé d'un assemblage cathodique de pulvérisation illustré de manière schématique à la figure 1, on a représenté en 1, une cible dont la surface de pulvérisation est représentée en 2. Cette cible est fixée sur une plaque 3 en cuivre formant support maintenue sur un refroidisseur 4 au moyen d'un clamp 5 tandis qu'une cuvette 6 creusée à partir de la partie supérieure du refroidisseur 4 sert à contenir un liquide, habituellement l'eau, destiné au refroidissement de ladite plaque 2.

On recherche les caractéristiques physiques du magnétron et, à cet effet, on repère sur l'assemblage cathodique la position des aimants permanents 7a et 7b et des pièces ferromagnétiques 8 et 9 de la cathode puis on mesure de manière conventionnelle et au moyen d'un appareil de mesure approprié l'induction magnétique totale soit $B_{total}$. Pour des raisons d'accessibilité, on réalise cette mesure au niveau de la surface de pose de la cible 1 sur la plaque de refroidissement 3. On pratique de cette façon à partir de l'axe central vertical z ou axe de symétrie vertical de cette cathode sur un segment de droite X-X' perpendiculaire à l'axe z et à l'axe central longitudinal y ou axe de symétrie longitudinal, et à différents endroits de ce segment de 120 mm de longueur.

On effectue de manière analogue la mesure de la composante verticale de cette induction magnétique, soit Bz.

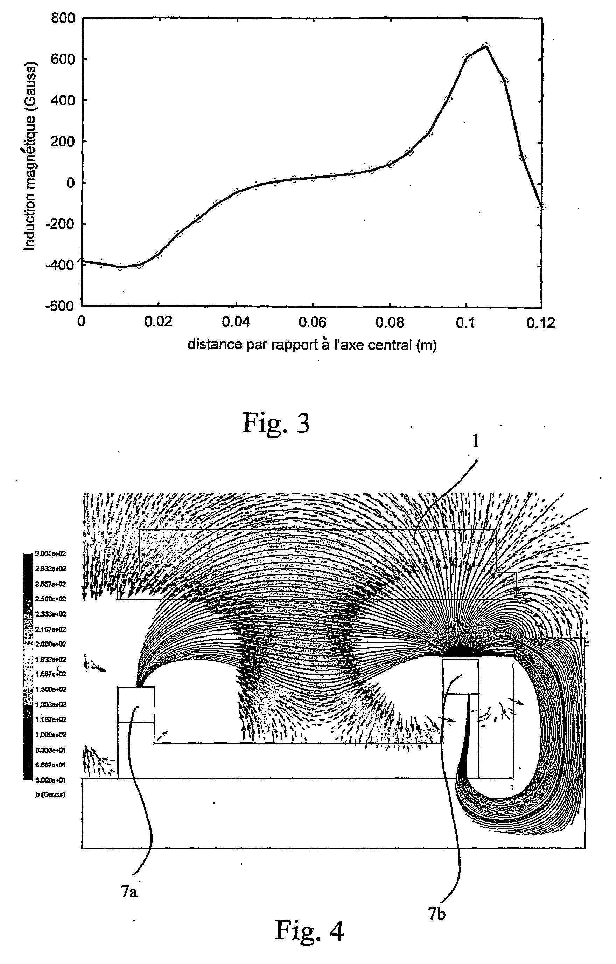

On a représenté aux figures 2 et 3 les courbes d'induction magnétique ainsi relevées pour $B_{total}$ et pour Bz respectivement.

A partir des caractéristiques physiques du magnétron et avec l'assistance d'un logiciel informatique approprié, on calcule alors $B_{total}$ et Bz par une méthode élément fini et on procède à une modélisation informatique bidimensionnelle de l'induction magnétique calculée tel qu'illustré à la figure 4.

Cette figure montre la géométrie modélisée de l'induction magnétique, l'induction magnétique représentée par des flèches et les lignes d'induction calculées de même que la position de la cible 1 virtuelle par rapport aux aimants 7a et 7b virtuels.

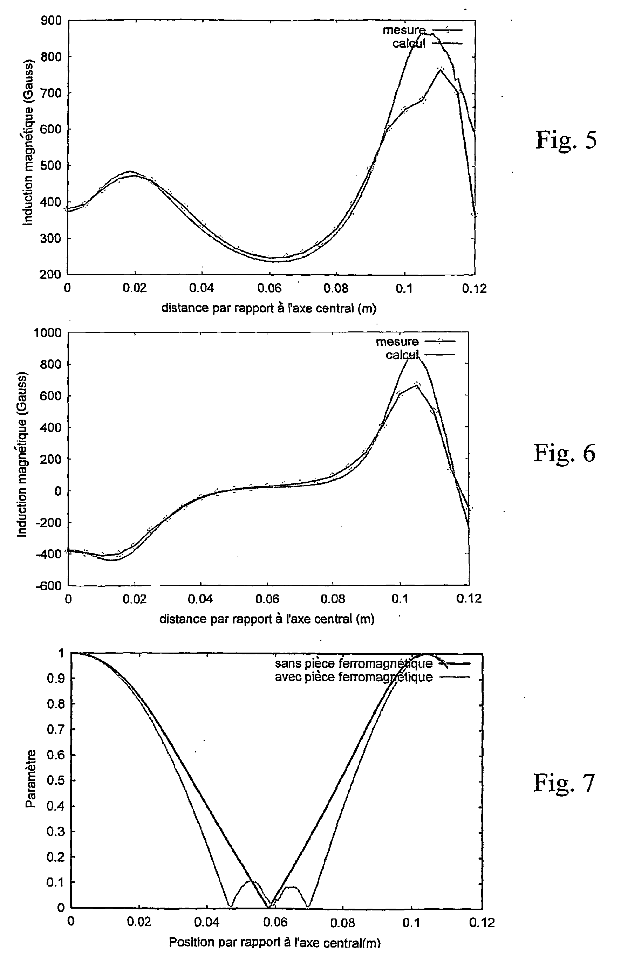

Une comparaison entre la courbe représentant $B_{total}$ calculé et la courbe représentant $B_{total}$ mesuré illustrée à la figure 2 permet de valider la modélisation proposée à la figure 5.

Une comparaison analogue effectuée entre la courbe représentant Bz calculé et celle représentant Bz mesuré tel que représenté à la figure 3 permet d'arriver à la même conclusion comme le montre la figure 6.

Dans une étape ultérieure, on intègre dans l'induction magnétique modélisée, une pièce ferromagnétique virtuelle de façon à provoquer une modification de la distribution de cette induction magnétique, dans le cas présent, en vue d'augmenter la courbure des lignes d'induction au niveau de la surface de pulvérisation 2 de la cible 1 virtuelle ou, d'une autre manière, de diminuer la valeur de Bz.

La figure 7 montre, sous forme graphique, une comparaison entre les valeurs du paramètre $\dfrac{Bz}{B_{total}}$, en l'absence ou en présence d'une pièce ferromagnétique, obtenues le long du segment de droite considéré X-X', au niveau de la surface de pulvérisation de la cible.

On observe qu'en l'absence de pièce ferromagnétique intégrée à la cible, $\dfrac{|Bz|}{B_{total}} = 0$ à une distance de 58 mm de l'axe central z de la cathode. A cet endroit, Bz est nul et les lignes d'induction magnétique sont parallèles à la surface de la cible.

Par contre, l'intégration d'une pièce ferromagnétique de forme et de dimension appropriées à un endroit déterminé de l'induction magnétique permet d'annuler également ce paramètre aux distances de 46 mm et 69 mm à partir de l'axe z et ainsi d'accroître le parallélisme des lignes d'induction par rapport à cette cible.

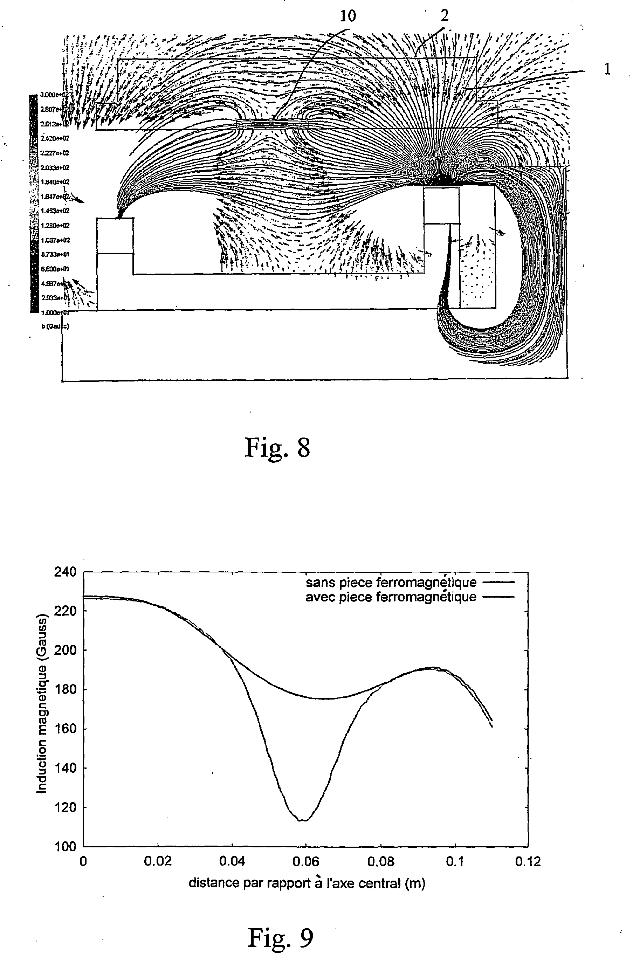

La modélisation du champ d'induction magnétique modifié au moyen de la pièce ferromagnétique 10 ci-dessus illustre parfaitement à la figure 8 l'augmentation du parallélisme des lignes d'induction au niveau de la surface de pulvérisation 2 de la cible 1 par rapport aux lignes d'induction au même endroit de la même cible exempte de pièce ferromagnétique tel que représenté à la figure 4.

Par ailleurs, comme le montre et le confirme la figure 9, la position choisie, pour l'intégration d'une pièce ferromagnétique peut être valablement retenue puisque l'induction magnétique reste supérieure à 100 gauss.

A l'endroit ainsi repéré de la cible de pulvérisation 1, on découpe et extrait une portion de celle-ci, portion dont les extrémités sont situées respectivement à 38 mm et 58 mm de l'axe z et on remplace le volume extrait par un volume équivalent de pièce ferromagnétique dont la surface extérieure affleure à la surface de pose de la cible 1 sur la plaque de refroidissement 3.

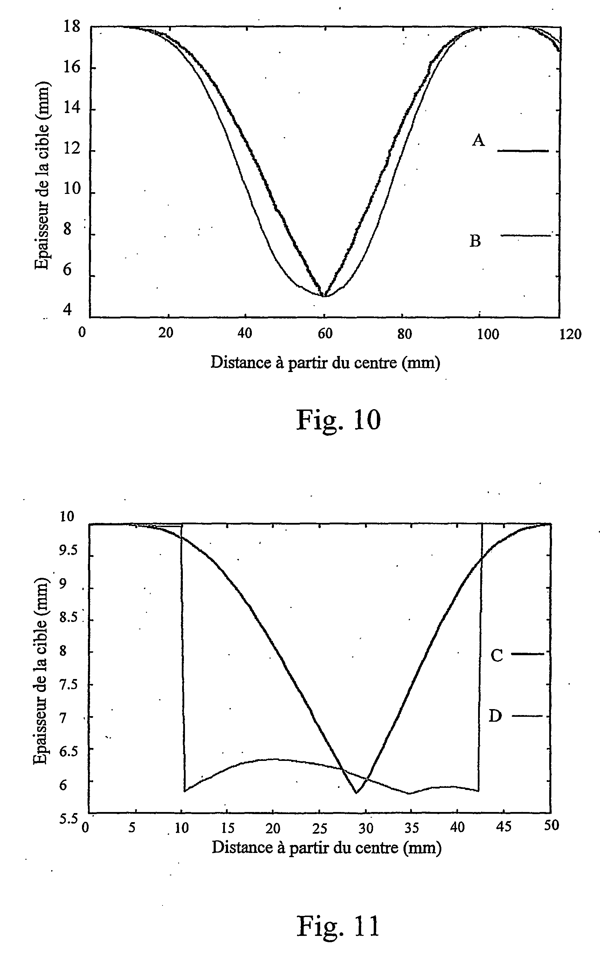

Une simulation par technique informatique de l'érosion, après pulvérisation cathodique de la cible faisant partie de l'ensemble ainsi fabriqué montre à la figure 10 un élargissement, significatif de la zone d'érosion illustré par la courbe B par rapport à l'érosion illustrée par la courbe A enregistrée chez une même cible exempte de pièce ferromagnétique insérée ou juxtaposée.

Dans l'exemple ci-dessus, la pièce ferromagnétique 10 est insérée à la partie inférieure de la cible. Toutefois, d'autres possibilités existent qui dépendent notamment des propriétés du matériau constitutif de la cible et des facilités d'usinage.

### EXEMPLE 2

De la même manière qu'à l'Exemple 1, on a fabriqué un ensemble comportant une cible de pulvérisation et une pièce ferromagnétique insérée dans celle-ci, l'ensemble étant configuré de manière à réduire la courbure de l'induction magnétique et accroître le parallélisme des lignes d'induction au niveau de la surface de pulvérisation de la cible.

Une simulation par technique informatique de l'érosion, après pulvérisation cathodique de la cible faisant partie de l'ensemble ainsi fabriqué montre à la figure 11 un élargissement extrêmement important de la zone d'érosion illustrée par la courbe D, par rapport à l'érosion illustrée par la courbe C, enregistrée chez une même cible exempte de pièce ferromagnétique insérée ou juxtaposée.

### Revendications

1. Méthode pour provoquer un accroissement du parallélisme, par rapport à la surface de la cible, des lignes d'induction magnétique créées par un magnétron de manière à améliorer l'uniformité de l'érosion sur la surface de pulvérisation d'une cible non ferromagnétique de pulvérisation cathodique magnétron et éventuellement pour indiquer la fin d'utilisation de cette cible, celle-ci étant couplée, par des moyens non magnétiques, audit magnétron maintenu stationnaire par rapport à cette cible, **caractérisée en ce que**, sans modifier les caractéristiques physiques du magnétron, l'on ajoute par insertion totale ou partielle dans ladite cible ou par juxtaposition contre l'une des parois de celle-ci, au moins une pièce ferromagnétique dont les caractéristiques d'emplacement, de forme et de grandeur sont prédéterminées, à partir des caractéristiques physiques non modifiées du magnétron, selon les résultats des étapes suivantes:

   a) comparaison des valeurs mesurées et des valeurs modélisées d'une part de l'induction ma-gnétique totale, soit $B_{total}$, créée par le magné-tron à la surface de pulvérisation de la cible et d'autre part de la composante vertical, par rapport à la surface de la cible, soit Bz, de cette induction magnétique,
   b) recherche dans cette induction modélisée des caractéristiques d'emplacement, de forme et de grandeur d'au moins une pièce ferromagnétique capable de provoquer au niveau de ladite surface de pulvérisation, l'accroissement souhaité du parallélisme des lignes d'induction magnétique,

   c) optimisation, au moyen du paramètre $\dfrac{Bz}{B_{total}}$, des emplacement, forme et grandeur repérés.

2. Méthode selon la revendication 1, **caractérisée en ce que** les caractéristiques d'emplacement, de forme et de grandeur de la pièce ferromagnétique sont prédéterminées, à partir des caractéristiques physiques non modifiées du magnétron, selon les résultats des étapes suivantes :

(a) mesure des valeurs de l'induction magnétique totale, soit $B_{total}$, créée par le magnétron à la surface de pulvérisation de la cible, et de la composante verticale, par rapport à la surface de la cible, soit Bz, de cette induction magnétique,

(b) calcul et modélisation, par technique informatique assistée par logiciel, de l'induction magnétique totale créée par le magnétron à la surface de pulvérisation de la cible, et de la composante verticale, par rapport à la surface de la cible de cette induction magnétique,

(c) validation de la modélisation par comparaison des valeurs calculées, d'une part de l'induction magnétique totale et d'autre part de sa composante verticale, par rapport à la surface de la cible, avec les valeurs mesurées correspondantes,

(d) recherche, dans cette induction modélisée, des caractéristiques d'emplacement, de forme et de grandeur d'au moins une pièce ferromagnétique qui, en contact avec la cible de pulvérisation, est capable de provoquer, au niveau de la surface de pulvérisation de cette cible, l'accroissement souhaité du parallélisme, par rapport à la surface de la cible des lignes d'induction magnétique,

(e) optimisation, au moyen du paramètre

$$\frac{Bz}{B_{total}},$$ des emplacement, forme et grandeur repérés.

3. Méthode selon la revendication 1 ou 2, **caractérisée en ce que** l'optimisation des emplacement, forme et grandeur s'opère par sélection de la ou des zones d'induction magnétique où la valeur du paramètre

$$\frac{Bz}{B_{total}}$$ est la plus faible possible, l'induction magnétique restant suffisante pour un confinement efficace des électrons au niveau de la surface de pulvérisation de la cible.

4. Méthode selon une des revendications 1 à 3, **caractérisée en ce que** l'on ajoute, par insertion totale ou partielle dans la cible de pulvérisation, au moins une pièce ferromagnétique.

5. Méthode selon une des revendications 1 à 3, **caractérisée en ce que** l'on ajoute, par juxtaposition contre l'une des parois de la cible de pulvérisation, au moins une pièce ferromagnétique.

6. Méthode selon une des revendications 1 à 3, **caractérisée en ce que** lorsque la cible est constituée d'un matériau à bas point de fusion, l'on ajoute par insertion, à partir des extrémités de la cible de pulvérisation ou de sa face inférieure ou juxtapose contre les parois des extrémités de cette cible ou contre la paroi de sa face inférieure, au moins une pièce ferromagnétique.

## Claims

1. Method for causing an increase in the parallelism, with respect to the surface of the target, of magnetic induction lines created by a magnetron so as to enhance the uniformity of the erosion on the sputtering surface of a non-ferromagnetic magnetron cathode sputtering target and optionally for indicating the end of use of said target, which is coupled, by non-magnetic means, to said magnetron held stationary with respect to said target, **characterised in that**, without modifying the physical properties of the magnetron, at least one ferromagnetic part is added by total or partial insertion in said target or by juxtaposition against one of the walls thereof, wherein the properties of position, shape and quantity of said ferromagnetic part are predetermined, on the basis of the non-modified physical properties of the magnetron, according to the results of the following steps:

a) comparing the measured values and the modelled values of the total magnetic induction, i.e. $B_{total}$, created by the magnetron at the target sputtering surface, and of the vertical component, with respect to the surface of the target, i.e. Bz, of said magnetic induction,

b) searching in this modelled induction for properties of position, shape and quantity of at least one ferromagnetic part capable of causing, at the level of said sputtering surface, the desired increase in the parallelism of the magnetic induction lines,

c) optimising, by means of the parameter $Bz/B_{total}$, the position, shape and quantity identified.

2. Method according to claim 1, **characterised in that** the properties of position, shape and quantity of the ferromagnetic part are predetermined, on the basis of unmodified physical properties of the magnetron, according to the results of the following steps:

a) measuring the values of the total magnetic induction, i.e. $B_{total}$, created by the magnetron at the target sputtering surface, and of the vertical component, with respect to the surface of the target, i.e. Bz, of said magnetic induction,

b) calculating and modelling, by a software-assisted computer technique, the total magnetic induction created by the magnetron at the target sputtering surface of the target, and the vertical component, with respect to the surface of the target, of this magnetic induction, and of the vertical component, with respect to the surface of the target, i.e. Bz, of said magnetic induction,

c) validating and modelling by comparing the calculated values of the total magnetic induction and the vertical component, with respect to the surface of the target, with the corresponding measured values,

d) searching in this modelled induction for properties of position, shape and quantity of at least one ferromagnetic part that, in contact with the sputtering target, is capable of causing, at the level of the sputtering surface of said target, the desired increase in the parallelism, with respect to the surface of the target, of the magnetic induction lines,

e) optimising, by means of the parameter $Bz/B_{total}$, the position, shape and quantity identified.

**3.** Method according to claim 1 or 2, **characterised in that** the optimisation of the position, shape and quantity is performed by selecting the magnetic induction zones in which the value of the parameter $Bz/B_{total}$ is as low as possible, with the magnetic induction remaining sufficient for an effective confinement of the electrons at the level of the sputtering surface of the target.

**4.** Method according to one of claims 1 to 3, **characterised in that** at least one ferromagnetic part is added by total or partial insertion into the sputtering target.

**5.** Method according to one of claims 1 to 3, **characterised in that** at least one ferromagnetic part is added by juxtaposition against one of the walls of the sputtering target.

**6.** Method according to one of claims 1 to 3, **characterised in that**, when the target is constituted by a material with a low melting point, at least one ferromagnetic part is added by insertion, from the ends of the sputtering target or the lower surface thereof, or is juxtaposed against the walls of the ends of said target or against the wall of the lower surface thereof.

**Patentansprüche**

**1.** Methode zur Erzielung einer stärkeren Parallelität der magnetischen Induktionslinien in Bezug auf die Targetoberfläche, die mit Hilfe eines Magnetrons hervorgerufen werden, in der Weise, dass die Gleichmässigkeit des Abtrags auf der Zerstäubungsoberfläche eines nicht ferromagnetischen Targets der Magnetron-Kathoden-Zerstäubung und um eventuell das Ende des Gebrauchs dieses Targets anzuzeigen, das durch nichtmagnetische Mittel mit besagtem Magnetron verbunden ist, welches in Bezug auf dieses Target stationär ist, **dadurch gekennzeichnet, dass** wenigstens ein ferromagnetisches Teil durch totale oder teilweise Einführung in das so genannte Target oder durch Juxtaposition gegen eine seiner Wände hinzugefügt wird, ohne die physikalischen Kenndaten des Magnetrons zu verändern, dessen Positions-, Form- und Größenkenndaten ausgehend von den physikalischen, nicht modifizierten Magnetronkenndaten entsprechend der nachfolgenden Schritte vorab bestimmt werden:

a) Vergleich der gemessenen Werte und der modellisierten Werte einerseits der Gesamtinduktion, also $B_{total}$, die durch das Magnetron an der Zerstäubungsoberfläche des Targets hervorgerufen wird, und andererseits des in Bezug auf die Targetoberfläche senkrechten Komponente, also Bz, dieser magnetischen Induktion;

b) Suche der Positions-, Form- und Größenkenndaten in dieser modellisierten Induktion von wenigstens einem ferromagnetischen Teil, das in der Lage ist, an der so genannten Zerstäubungsoberfläche die gewünschte Zunahme der Parallelität der magnetischen Induktionslinien zu erzeugen;

c) Optimierung mittels des Parameters $Bz/B_{total}$ der markierten Position, Form und Größe.

**2.** Methode nach Anspruch 1, **dadurch gekennzeichnet, dass** die Positions-, Form- und Größenkenndaten des ferromagnetischen Teils ausgehend von den physikalischen, nicht modifizierten Magnetronkenndaten entsprechend den Ergebnissen der nachfolgenden Schritte vorab bestimmt werden:

(a) Messung der Werte der magnetischen Gesamtinduktion, also $B_{total}$, die durch das Magnetron an der Zerstäubungsoberfläche des Targets erzeugt wird, und der in Bezug auf die Targetoberfläche senkrechten Komponente, also Bz, dieser magnetischen Induktion;

(b) Berechnung und Modellisierung mit programmgestützter Informatik der gesamten magnetischen Induktion, die durch das Magnetron an der Zerstäubungsoberfläche des Targets erzeugt wird, und der in Bezug auf die Targetoberfläche senkrechten Komponente dieser magnetischen Induktion;

(c) Freigabe der Modellisierung durch Vergleich der berechneten Werte, einerseits der magnetischen Gesamtinduktion und andererseits der in Bezug auf die Targetoberfläche senkrechten Komponente mit den entsprechenden gemessenen Werten;

(d) Suche der Positions-, Form- und Grössenkenndaten in dieser modellisierten Induktion von wenigstens einem ferromagnetischen Teil, das in Kontakt mit dem Zerstäubungstarget fähig ist, an der Zerstäubungsoberfläche dieses Targets die gewünschte Zunahme der Parallelität der magnetischen Induktionslinien in Bezug auf die Targetoberfläche hervorzurufen;

(e) Optimierung mittels des Parameters $Bz/B_{total}$ der markierten Position, Form und Größe.

3. Methode nach Anspruch 1 oder 2, **dadurch gekennzeichnet, dass** die Optimierung von Position, Form und Größe durch Auswahl einer oder mehrerer Zonen der magnetischen Induktion erfolgt, wo der Wert des Parameters $Bz/B_{total}$ der geringste ist, wobei die magnetische Induktion ausreichend gross für ein wirksames Begrenzen der Elektronen an der Zerstäubungsoberfläche des Targets bleibt.

4. Methode nach einem der Ansprüche 1 bis 3, **gekennzeichnet dadurch, dass** wenigstens ein ferromagnetisches Teil durch totales oder teilweises Einfügen in das Zerstäubungstarget hinzugefügt wird.

5. Methode nach einem der Ansprüche 1 bis 3, **dadurch gekennzeichnet, dass** wenigstens ein ferromagnetisches Teil durch Juxtaposition gegen eine der Wände des Zerstäubungstargets hinzugefügt wird.

6. Methode nach einem der Ansprüche 1 bis 3, **dadurch gekennzeichnet, dass** wenigstens ein ferromagnetisches Teil durch Einführen ausgehend von den Enden des Zerstäubungstargets oder seiner Unterseite oder durch Juxtaposition gegen die Wände der Enden dieses Targets oder gegen die Wand seiner Unterseite hinzugefügt wird, wenn das Target aus einem Material mit niedrigem Fusionspunkt besteht.

Fig. 1

Fig. 2

Fig. 3

Fig. 4

Fig. 5

Fig. 6

Fig. 7

Fig. 8

distance par rapport à l'axe central (m)

Fig. 9

Fig. 10

Fig. 11

14